(19) Europäisches Patentamt / European Patent Office / Office européen des brevets

(11) **EP 1 798 315 A2**

(12) **EUROPÄISCHE PATENTANMELDUNG**

(43) Veröffentlichungstag:
**20.06.2007 Patentblatt 2007/25**

(51) Int Cl.:
*C30B 11/00* (2006.01)   *C30B 29/12* (2006.01)

(21) Anmeldenummer: **06025710.2**

(22) Anmeldetag: **12.12.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **13.12.2005 DE 102005059531**

(71) Anmelder: **Schott AG**
**55122 Mainz (DE)**

(72) Erfinder:
• **Weisleder, Andreas**
**07639 Tautenheim (DE)**

• **Mueller, Matthias, Dr.**
**07745 Jena (DE)**
• **Kandler, Joerg, Dr.**
**07751 Cospeda (DE)**
• **Menzel, Andreas**
**07745 Jena (DE)**
• **Guett, Rainer**
**07639 Bad Klosterlausnitz (DE)**

(74) Vertreter: **Fuchs Mehler Weiss & Fritzsche**
**Naupliastrasse 110**
**81545 München (DE)**

(54) **Herstellung hochreiner großvolumiger Einkristalle aus Kristallscherben**

(57)   Es wird ein Verfahren zur Herstellung hochreiner, besonders strahlungsbeständiger großvolumiger Einkristalle mit geringer intrinsischer Spannungsdoppelbrechung beschrieben. Dabei wird aus einer Schmelze aus Kristallrohmaterial unter kontrolliertem Abkühlen unter Erstarrung ein Kristall erzeugt. Als Kristallrohmaterial werden Scherben und/oder Verschnitt von bereits gezüchteten Kristallen verwendet, wobei das wieder verwendete Rohmaterial
1) bei einer visuellen Betrachtung bei Tageslicht keine Farbe aufweist und
2) beim Bestrahlen mit einer Weißlichtlampe in einem Dunkelraum
a) keine oder maximal eine gerade noch wahrnehmbare rötliche und/oder bläuliche Fluoreszenz aufweist und
b) keine oder maximal gerade noch wahrnehmbare diffuse Streuung aufweist und
c) keine oder nur noch schwache diskrete Streuung von maximal zwei visuell wahrnehmbaren Streuzentren pro $dm^3$ aufweist.

Auf diese Weise sind Kristalle erhältlich, die nach einer Temperung einen BSDF-Wert $<7 \times 10^{-7}$, eine RMS-Homogenität nach Abzug von 36 Zernikekoeffizienten von $<15 \times 10^{-8}$, sowie einen SDB-RMS-Wert in 111 Richtung $<0,2$ nm/cm aufweisen.

EP 1 798 315 A2

**Beschreibung**

Die Erfindung betrifft ein Verfahren zur Züchtung von Einkristallen aus Scherben bereits gezüchteter Kristalle, derart erhaltene Kristalle sowie deren Verwendung als optische Elemente, insbesonders in der Photolithographie.

Die Herstellung von Kristallen, insbesondere für die Photolithographie ist generell bekannt und beispielsweise in der EP-A 1 259 663 beschrieben. Danach werden großvolumige Einkristalle mit einheitlicher Orientierung aus einer Schmelze aus Kristallrohmaterial gezüchtet, indem die Temperatur der Schmelze am Boden eines Schmelz- und Zuchtgefäßes langsam auf die Kristallisationstemperatur abgekühlt wird. Zwischen dem Boden des Schmelzgefäßes und der Öffnung wird ein senkrecht verlaufender axialer Temperaturgradient angelegt und ein durch die Seitenwände verlaufender Wärmezu- oder -abfluss vermieden. Dabei wird die Kristallorientierung mittels eines Keimkristalls vorgegeben, der insbesondere in einer gekühlten Keimtasche angeordnet ist. Bei der Züchtung und bei der Weiterverarbeitung solcher Kristalle zu optischen Elementen werden diese zerteilt, wodurch eine große Menge an Material als Verschnitt, als Bruch oder auch durch Fehlzüchtungen entsteht, im Folgenden Scherben genannt. Diese Scherben wurden bislang entsorgt, obwohl sie nicht giftig sind, was die Produktionskosten erhöht.

Es ist bereits versucht worden, Scherben aus der Zucht von Kalziumfluorideinkristallen wieder zu verwenden indem diese in einem Vakuum von max. 5 mal $10^{-4}$ mbar bei einer Temperatur von mindestens 1100°C verdampft und bei einer Temperatur zwischen 500°C und 1280°C wieder kondensiert werden. Ein solches Verfahren ist in der DE 10 2004 008 749 A1 beschrieben.

Aus der Glasherstellung ist es nun bekannt, Scherben und Bruch einzuschmelzen und einer erneuten Verwendung zuzuführen. Dies dient sowohl der Einsparung von Rohstoffen, vor allem aber auch zur Einsparung von Energie, die sonst zum Läutern und zur Ausbildung der chemischen Reaktionen benötigt wird, die dann zur fertigen Glasschmelze führen. Bei der Herstellung von Kristallen finden jedoch derartige Energieeinsparungen nicht statt, so dass die aufgewandte Energie für das Aufschmelzen von dem bislang verwendeten, hochreinen Kristallrohpulver und dem Einschmelzen von Scherben gleich ist. Die Verwendung von Scherben zur Einsparung von Rohstoffen bringt jedoch die Gefahr einer Kontamination mit sich, so dass bei aufwändigen, teuren und langandauernden Zuchtverfahren bislang lieber teure, hochreine Ausgangsmaterialien mit einer Reinheit von > 99,999% verwendet wurden als derartige Scherben wieder aufzubereiten.

Die Erfindung hat nun zum Ziel, besonders streufreie Kristalle mit hoher Brechzahlhomogenität und geringer Spannungsdoppelbrechung bereitzustellen. Die Erfindung hat außerdem zum Ziel, bereits verbrauchtes Rohmaterial, Verschnitt und Abfall aus früheren Kristallzuchten wieder zu verwenden und zu recyceln.

Dieses Ziel wird mit den in den unabhängigen Ansprüchen definierten Merkmalen erreicht.

Erfindungsgemäß wurde nämlich gefunden, dass sich mit verbrauchten Scherben nicht nur gute Kristalle herstellen lassen, sondern dass sich damit sogar Kristalle herstellen lassen, welche eine bessere, überragende Laserstabilität zeigen als die mit dem bisherigen Verfahren erhältlichen, wenn Scherben verwendet werden, die vor ihrem Aufschmelzen die im Folgenden beschriebenen Eigenschaften beziehungsweise Merkmale aufweisen.

Diese Eigenschaften beziehungsweise Merkmale werden zweckmäßigerweise an Rohkristallen oder Proben aus Rohkristallen bestimmt und zwar zweckmäßigerweise nach ihrer Zucht und insbesondere nach Abtrennung von Deckschicht (Zuchtende) und gegebenenfalls des Kegelbodens aber vorzugsweise vor der Zerteilung des Kristalls in einzelne Linsenrohlinge. Fallen im weiteren Fertigungsprozess aus dem Volumen eines bereits beurteilten Rohkristalles weitere Scherben an, so werden diesen Scherben die zuvor bestimmten Merkmale zugeordnet. Prinzipiell ist es natürlich auch möglich die jeweiligen Scherben einzeln zu klassifizieren bzw. bewerten, sofern sie eine ausreichende Größe aufweisen.

Der Begriff Scherben umfasst Kristallmaterial folgender Herkunft:

- geometrischer Verschnitt, der beim Herausschneiden von zu Produkten verarbeitungsfähigem Material aus dem Volumen eines bereits gezüchteten Rohkristalls entsteht.
- Bruch bzw. geometrisch beschädigtes Kristallmaterial, dass in der Weiterverarbeitung herausgeschnittenen Materiales zu Produkten entstand.
- Probenmaterial, welches nicht mehr benötigt wird.
- Hergestelltes Kristallmaterial, dass die Spezifikationskriterien für bestimmte Verwendungen nicht erfüllt, aber den Spezifikationsanforderungen für den Wiedereinsatz als Scherben gerecht wird.

Ein Rohkristall, aus dem Scherben für den Wiedereinsatz gewonnen werden können, ist ein Einkristall der im Idealfall in seinem gesamten Volumen einkristallin ist. Im Realfall besteht sein Volumen jedoch aus wenigen einkristallinen Hauptblöcken, deren Anzahl maximal 5 ist und von denen jeder mindestens 20% Volumenanteil am Rohkristall hat. Der Rohkristall gilt auch dann noch als einkristallin, wenn er aus maximal 20 Blöcken besteht, von denen ein jeder eine Größe von geringer als 20% des Rohkristallvolumens aufweist. Übersteigt die Blockanzahl 20, so wird der Rohkristall nicht mehr als einkristallin sondern als polykristallin bezeichnet. Ein solcher Kristall fällt nicht mehr unter die Definition ,Rohkristall' im Sinne dieser Erfindung.

Ein erster Test oder Grobansichtsverfahren betrifft die Beurteilung auf Farbe. Dabei wird ein gezüchteter Rohkristall, der eine allseitig geschliffene Oberfläche erhielt, mit einer Immersionsflüssigkeit benetzt. Dazu können handelsübliche Produkte wie Silicon fluid SF 1202 der Fa. GE Silicones oder Paraffin flüssig Reagenz PhEur der Fa. Merck (Darmstadt, Deutschland) verwendet werden. Der Kristall wird nun mit Tageslicht beleuchtet und nur mit bloßem Auge betrachtet. Sind dabei keine Farben wahrnehmbar, dann sind zu einem später im Bearbeitungsprozess aus diesem Kristall entstehende Scherben für den Wiedereinsatz geeignet.

In einem weiteren zweiten Test wird der Rohkristall in einem Dunkelraum auf das Auftreten einer Fluoreszenz getestet. Dabei wird er mit einer Weißlichtlampe durchstrahlt. Vorzugsweise ist die Weißlichtlampe schwach divergierend eingestellt. Treten hierbei stärkere Fluoreszenzen auf, sind zu einem später im Bearbeitungsprozess aus diesem Rohkristall entstehende Scherben nicht für den Wiedereinsatz geeignet und werden aussortiert.

Ist von einem ungeschulten Auge des Betrachters im Dunkelraum nach Adaption des Auges keine oder eine rötliche oder auch bläuliche Fluoreszenz sichtbar, die jedoch in einem normal beleuchteten Arbeitsraum von diesem Betrachter nicht mehr wahrnehmbar ist, dann sind Scherben aus diesem Rohkristall für den Wiedereinsatz geeignet. Die Oberfläche des untersuchten Rohkristalles wird zur Bestimmung der Fluoreszenz mit einer der bereits genannten, üblichen Immersionsflüssigkeiten benetzt. Bei diesem Test wird der Strahl der Weisslichtlampe vorzugsweise so geführt, dass alle Teile des Volumens des Kristalls einmal durchstrahlt und somit bewertet werden können.

Als Lampe für eine solche Weißlichtbestrahlung wird beispielsweise eine Halogenlampe der Firma Osram mit der Handelsbezeichnung Xenophot HLX 54510 (12V, 50W) verwendet, deren Strahl durch einen Reflektor und durch Kondensor schwach divergierend eingestellt wird. Die Bestimmung der Fluoreszenz erfolgt dabei wir folgt:

Wird gar keine Fluoreszenz festgestellt, dann erhält der Kristall die Bewertung die Fluoreszenzklasse 0. Wird eine Fluoreszenz festgestellt, die nur von geschultem Personal und nach Adaption des Auges im Dunkelraum erkennbar ist, wird diese als schwach bzw. mit der Fluoreszenzklasse 1 eingestuft.

Ist die Fluoreszenz auch von einem Laien im Dunkelraum erkennbar, jedoch nicht bei Tageslicht oder in einem beleuchteten Raum wahrnehmbar, dann wird die Fluoreszenz als mittel oder als Klasse 2 eingestuft. Eine starke Fluoreszenz kann hingegen von jedermann auch außerhalb der Dunkelkammer und ohne weiteres visuell wahrgenommen werden. Scherben aus Rohkristallen, die eine derart starke Fluoreszenz zeigen, sind für eine Wiederverwendung nicht verwendbar. Solche Kristalle werden als stark fluoreszierend oder als zur Fluoreszenzklasse 3 gehörig klassifiziert und Scherben daraus sind zu verwerfen.

Anschließend wird im Dunkelraum mit einer Bestrahlung unter Weißlicht, vorzugsweise mit der gleichen Lampe, mit der auch die Fluoreszenz bestimmt wird, die diffuse Streuung des Kristalles bestimmt. Dabei wird der Rohkristall in seinem Volumen vom Licht durchstrahlt und die Streuung ebenfalls nach Adaption des Auges an den dunklen Raum visuell bestimmt. Dabei wird eine Streuung als diffus bezeichnet, wenn das Auge des Beurteilers keine einzelnen Streuzentren auflösen kann und das beleuchtete Kristallvolumen gleichmäßig erleuchtet erscheint. Eine schwache diffuse Streuung bedeutet, dass sie nur für ein geschultes Auge eines Fachmanns im Dunkelraum wahrnehmbar ist, wohingegen eine nicht mehr zulässige, mittlere Streuung selbst für einen Laien erkennbar ist. Für das erfindungsgemäße Verfahren sind lediglich solche Scherben aus Kristallen weiter zu verwenden, wenn diese keine oder eine nur schwache, diffuse Streuung zeigen. Scherben aus stärker diffus streuenden Kristallen sind zu verwerfen.

Ist auch dieses Merkmal erfüllt, wird der Rohkristall einem weiteren Test auf diskrete Streuung unterzogen. Dabei bedeutet eine diskrete Streuung, dass das Auge des Beurteilers punkt- oder auch streifenförmige Streuzentren wahrnimmt. Derartige Streuzentren werden beispielsweise durch kleine Vakuolen oder auch durch Kristallausscheidungen gebildet. Dabei werden für das erfindungsgemäße Verfahren nur solche Scherben verwendet, die maximal zwei Streuzentren pro $dm^3$ aufweisen. Vorzugsweise weisen sie jedoch nicht mehr als ein Streuzentrum pro $dm^3$ und insbesonders maximal 0,5 Streuzentren pro $dm^3$ auf. Sowohl die diffuse als auch die diskrete Streuung dürfen für die erfindungsgemäße Wiederverwendung nur einen vernachlässigbar geringen Verlustbeitrag bei der Transmission verursachen. Ein weiteres Kriterium für den Wiedereinsatz von Scherben durch Ermittlung der noch zulässigen Transmissionsmessung ist die weiter unten beschriebene Bestimmung des dekadischen, initialen Verlustkoeffizienten.

Scherben aus Rohkristallen, die nicht sämtliche der oben genannten Kriterien erfüllen, sind zu verwerfen und für das erfindungsgemäße Herstellungsverfahren nicht verwendbar.

In einer bevorzugten erfindungsgemäßen Ausführungsform wird der Kristall noch weiteren Tests unterzogen. Ein erster bevorzugter additiver Test betrifft die Bestimmung von Kleinwinkelkorngrenzen. Unter Kleinwinkelkorngrenzen werden innerhalb eines Einkristalles Verkippungen der Kristallachsen von Subkörnern gegeneinander verstanden, die zueinander einen Winkel von maximal ca. 5° bilden. Es wurde nun gefunden, dass sich für das erfindungsgemäße Verfahren vorzugsweise solche Scherben eignen, an deren Kleinwinkelkorngrenzen Verkippungen von Subkörnern von maximal 2° auftreten, d. h. deren Achsen zueinander um maximal 2° verkippt sind. Vorzugsweise sind diese jedoch um nicht mehr als 1,5°, insbesondere maximal 1° verkippt. In einer ganz bevorzugten erfindungsgemäßen Ausführungsform sind diese jedoch nicht mehr als um 0,8° verkippt. Die Bestimmung der Kleinwinkelkorngrenzen ist an sich bekannt und wird üblicherweise im Polariskop durchgeführt. Dabei wird der zu untersuchende Rohkristall ebenfalls mittels einer Immersionsflüssigkeit benetzt und zwischen zwei gekreuzte Polarisatoren gestellt. Erfindungsgemäß wird dabei der Rohrkristall zwischen den Polarisatoren vorzugsweise mit geschliffenen, insbesondere allseitig geschliffenen Oberflächen angeordnet. Die Bestimmung der Verkippung erfolgt dann anhand von Vergleichskörpern, deren Verkippungswinkel mittels Röntgendiffraktormetrie, z. B. mittels einer als Crysotax-Sonde bezeichneten Vorrichtung der Firma Röntec, zuvor bestimmt worden ist. Die Stärke von hell-/dunkel-Erscheinungen der Vergleichskörper werden so mit den gemessenen Verkippungswinkeln skaliert und damit die Bewertbarkeit des untersuchten Rohrkristalles anhand von hell-/dunkel-Erscheinungen gesichert. Prinzipiell ist es auch möglich, an jedem Scherben die Verkippung mittels der Röntgendiffraktormetrie zu bestimmen, was jedoch einen sehr hohen und ungerechtfertigten Aufwand bedeutet. Daher wird im erfindungsgemäßen Verfahren der Vergleich der hell-/dunkel-Erscheinungen am Polariskop durchgeführt. Ein solches Polariskop kann z.B. das SP 300 der Firma Kombinat Carl Zeiss Jena sein, und die Untersuchungsmethode ist in der TGL 21792 in der Fassung vom Januar 1989 detailliert beschrieben. Aber auch in der Fachliteratur ist die Methode z. B. in H. Jebsen-Marwedel und R. Brückner "Glastechnische Fabrikationsfehler", Springer Verlag, 3. Auflage 1980 beschrieben.

Bei der Bestimmung der Kleinwinkelkorngrenzen im Polariskop erfolgt die Bewertung des hell-/dunkel-Bildes und daraufhin die Zuordnung des Rohrkristalles zu folgenden Kleinwinkelkorngrenzenklassen:

0 = keine wahrnehmbaren Kleinwinkelkorngrenzen,
eine schwache (Klasse 1) = Kleinwinkelkorngrenzen sind nur unter unterschiedlichen Betrachtungswinkeln des Beobachters zwischen den gekreuzten Polarisatoren erkennbar,
eine mittlere (Klasse 2) = Kleinwinkelkorngrenzen zeigt eine graue Tönung in dem jeweiligen Bereich an(Klasse 2 entspricht entsprechend oben beschriebener Eichung einem Verkippungswinkel von 2°) und
eine starke (Klasse 3) = Kleinwinkelkorngrenzen sind deutlich zwischen den gekreuzten Polarisatoren auch für Laien erkennbar.

Ein weiterer, gegebenenfalls zusätzlicher Test betrifft die Bestimmung des dekadischen, initialen Verlustkoeffizienten, insbesonders bei 193 nm für die Energiedichte Null. Die Bestimmung dieses initialen Verlustkoeffizienten ist beispielsweise in der DE 103 35 457 A1 beschrieben. Dabei wird die Transmission bei Laserbestrahlung mit unterschiedlichen Energiedichten ermittelt und die erhaltenen Messwerte auf den Wert bei einer Energiedichte von Null extrapoliert. Dieser Wert wird als die initiale Transmission bezeichnet. Hieraus lässt sich der jeweilige initiale Verlustkoeffizient k berechnen. Prinzipiell ist es auch möglich, den dekadischen Verlustkoeffizienten k bei 193 mit einem Spektrometer (z. B. Lambda 900 der Firma Perkin Elmer), welches durch die verwendete Lampenanregung nur einen Messstrahl sehr geringer Energiedichte verwendet, zu bestimmen. Unabhängig wie der Transmissionswert bei der Energiedichte Null (bei Laserverwendungen) oder nahe am Energiewert Null (bei der Verwendung von Spektrometern) bestimmt wurde, wird der dekadische Verlustkoeffizient nach folgender Formel bestimmt:

$$T = (1-R)^2 \times 10^{-kd},$$

wobei T die mittels Spektrometer gemessene Gesamttransmission bzw. der auf Energiedichte Null extrapolierte Transmissionswert aus mehreren Lasermessungen bei unterschiedlichen Energiedichten ist,
d die Probendicke in cm darstellt und
k der dekadische initiale Verlustkoeffizient in $cm^{-1}$ darstellt und
R der Reflektionsverlust an einer Oberfläche bei senkrechtem Lichteinfall ist. Dabei wird der Reflektionsverlust R wie folgt berechnet:

$$R = \left( \frac{n-1}{n+1} \right)^2$$

In dem bevorzugten erfindungsgemäßen Verfahren werden dabei sämtliche Scherben aus einem Rohrkristall verworfen, dessen Messprobe einen k-Wert von > 5 x $10^{-4}$ $cm^{-1}$ aufweist.
Bei Berechnung des Verlustkoeffizienten k aus der gemessenen Transmission durch eine Probendicke d enthält k einen Verlustanteil aus Streuung und einen Verlustanteil aus Absorption. Durch die bereits in einem vorangegangenen Test nur limitiert zugelassene Streuung ist sichergestellt, dass das Merkmal Verlustkoeffizient k zusätzlich herangezogen werden kann.

Wenn ein Scherben die zuvor genannten Merkmale erfüllt, wird er vorzugsweise von Verschmutzungen und Kontaminationen gereinigt, die an seiner Oberfläche haften. Derartige Kontaminationen sind beispielsweise Beschriftungen, Kristallabrieb, Staub, Immersionsflüssigkeit, etc. Die Reinigung selbst kann sowohl von Hand als auch maschinell erfolgen.

Die Handwäsche erfolgt üblicherweise durch Abreiben mittels einem insbesonders fussel- und flusenfreien, tuchartigen, textilen Flächengebilde, das mit ein Reinigungsmittel enthaltendes Wasser und/oder einem organischen Lösungsmittel wie beispielsweise Alkohol, insbesonders Ethanol, getränkt ist. Anschließend wird der Scherben mit reinem Wasser, insbesonders destilliertem oder entionisiertem Wasser abgespült, um sämtliche noch an der Oberfläche verbleibende Lösungsmittel- und/oder Reinigungsmittelreste zu entfernen. Danach werden die Scherben vorzugsweise in einer staubreduzierten Umgebung an der Luft vorgetrocknet, wonach eine weitere Trocknung in einem Wärmeofen bei erhöhter Temperatur, vorzugsweise zwischen 50 und 90°, insbesonders zwischen 60 und 80° über einen Zeitraum von mindestens 60, insbesonders mindestens 75 Min getrocknet. Übliche maximale Trocknungszeiten betragen 150, insbesonders 120 Min, wobei max. 100 Min sich als besonders zweckmäßig erwiesen haben. Nach dem Abkühlen sind die Scherben für einen erneuten Zuchtprozess verwendbar.

Die maschinelle Reinigung kann entweder mittels einem Sprühstrahl wie in einem Geschirrspüler oder mittels einem oder mehreren Ultraschallbädern erfolgen. Bei der Reinigung mittels Sprühstrahl wird üblicherweise eine handelsübliche Geschirrspülmaschine verwendet. Dabei werden die Scherben derart in den Reinigungskorb gelegt, dass diese einander nicht berühren. Das Waschen selbst erfolgt mit einem Reinstwasser unter Zusatz eines Reinigungsmittels. Hier hatten sich zweckmäßigerweise nicht-tensidische, insbesonders nichtionische Reinigungsmittel bewert. Besonders bevorzugt sind Reinigungsmittel, welche keine Alkaliionen enthalten. Ein typisches Reinigungsmittel wird beispielsweise unter dem Handelsnamen Vigon A von der Dr. Mack GmbH, Ingolstadt, Deutschland, vertrieben. Der Waschvorgang selbst erfolgt bei Temperaturen zwischen Raumtemperatur bis ca. 90°C, insbesondere bis ca. 80°C vorzugsweise bis ca. 70°C, und zwar über einen Zeitraum wie er üblicherweise von Geschirrspülmaschinen voreingestellt ist. Derartige Zeiträume sind üblicherweise max. 60 Minuten. Danach erfolgten mindestens zwei, vorzugsweise jedoch mindestens drei Spülvorgänge mit Reinstwasser, wobei sich vier Spülvorgänge als zweckmäßig erwiesen haben. Nach erfolgter Lufttrocknung bei mindestens 100, insbesondere mindestens 110°C werden die Scherben in einem Vakuumtrockenofen wie zuvor bei der Handwäsche beschrieben getrocknet.

Die Reinigung mit Ultraschall wird üblicherweise derart durchgeführt, dass die Scherben in einen Korb derart eingeordnet werden, dass sie einander nicht berühren und zuerst in einer Fließspüle mit enthärtetem Wasser abgespült werden. Anschließend werden sie in ein Reinigungsmittel enthaltendes Ultraschallbad gelegt. Typische Reinigungsmittel sind beispielsweise die gleichen wie bei der Sprühstrahlreinigung im Geschirrspüler. Ein typisches Reinigungsmittel hierfür ist N-Methylpyrrolidon. Dabei wird der Korb mit den Scherben im Ultraschallreinigungsbad vorzugsweise bewegt. Eine übliche Reinigungszeit beträgt zwischen 20 und 80 Minuten, insbesondere zwischen 30 und 60 Minuten bei einer Reinigungstemperatur von Raumtemperatur bis 70, insbesondere von ca. 30 bis 50°C, wobei ca. 40°C bevorzugt ist. Nach kurzer Spülung wird dieser Vorgang in einem zweiten Ultraschallbad wiederholt. Danach erfolgt eine Spülung in einem Spülbad mit ständig fließendem Reinstwasser für einen Zeitraum von ca. zwei bis zehn, insbesondere drei bis sieben Minuten, wobei ca. fünf Minuten bevorzugt sind. Die Temperatur beim Spülen beträgt ca. 30 bis 50, insbesondere ca. 40°C. Dieser Spülvorgang wird wiederholt und anschließend werden die Scherben wie zuvor beschrieben erst an Luft und dann in einem Vakuumtrockenofen getrocknet. Die so erhaltenen Scherben sind sofort für einen erneuten Zuchtprozess verwendbar. Müssen die Scherben länger bis zu ihrer Verwendung gelagert werden, werden sie vorzugsweise unter Vakuum gelagert, was zweckmäßigerweise durch Einschweißen in handelsübliche Folienbeutel geschieht.

Die so erhaltenen Scherben können nun für die Kristallzucht verwendet werden. Dabei können diese allein unter Verwendung eines üblichen Scavengers direkt zur Kristallzucht eingesetzt werden oder auch mittels Zusatz von üblichem Rohmaterial. In vielen Fällen hat sich die Herstellung eines sog. Ingots, d.h. eines polykristallinen großvolumigen Körpers als zweckmäßig erwiesen. Der derartige Ingot wird dann in die Kristallzuchtanlage eingesetzt, aufgeschmolzen und aus dieser Schmelze der gewünschte Kristall gezüchtet.

Mittels dem erfindungsgemäßen Verfahren ist es nicht nur möglich, teures Rohmaterial wieder zu verwenden, sondern es hat sich überraschenderweise auch gezeigt, dass sich mit einem derart selektierten Scherben bessere und reinere Kristalle züchten lassen, die für Anwendungen mit Lasern einer Arbeitswellenlänge unter 200 nm, wie beispielsweise 193 nm und 157 nm geeignet sind. Derart hergestellte Kristalle lassen sich sehr gut tempern, d. h. ihre Neigung nach Temperung eine erhöhte diffuse Streuung aufzuweisen, ist überraschenderweise sehr gering. Aufgrund dieser guten Temperfähigkeit werden sehr gute Werte der Spannungsdoppelbrechung und der Brechzahlhomogenität erreicht, wodurch sie vor allem in der Projektionsoptik eines Steppers Verwendung finden. Sie sind außerdem besonders widerstandsfähig gegenüber DUV-Laserstrahlung und sind aus diesem Grund auch sehr gut für die Anwendung im Beleuchtungssystem eines Steppers geeignet.

Übliche erfindungsgemäß erhaltene Kristalle weisen einen Wert für die diffuse Streuung (Bidirectional Scatter Distribution Function - Wert) von $<1{,}3 \times 10^{-6}$, insbesondere $<7 \times 10^{-7}$ auf. Derartige Werte waren bislang nicht erhältlich. Besonders bevorzugte erfindungsgemäße Kristalle zeigen einen BSDF-Wert von $<5$, insbesondere $<3 \times 10^{-7}$. Die Be-

stimmung solcher BSDF-Werte ist dem Fachmann bekannt und beispielsweise in Stover J. C. - Optical Scattering - measurement and analysis, McGraw-Hill, 1990 beschrieben. Darüber hinaus zeigen die erfindungsgemäßen Kristalle nach Durchführung eines Temperschrittes eine besonders hohe Homogenität des Brechungsindexes und zwar insbesondere eine Homogenität in den RMS-Werten (nach Abzug von 36 Zernikekoeffizienten wie in der WO 2005/080948 beschrieben). Typische erfindungsgemäße Kristalle zeigen eine RMS-Homogenität von <15 x 10$^{-8}$, insbesondere <10 x 10$^{-8}$, wobei <2,5 x 10$^{-8}$ bevorzugt und <1,5 x 10$^{-8}$ besonders bevorzugt ist. Die Spannungsdoppelbrechung (SDB - RMS) beträgt in (100) sowie in (110) Orientierung vorzugsweise weniger als 1 nm/cm, insbesondere <0,35 nm/cm, wobei <0,3 nm/cm besonders bevorzugt ist. In (111) Richtung beträgt der SDB-RMS-Wert üblicherweise weniger als 0,2 nm/cm, wobei <0,15 nm/cm und insbesondere <0,08 nm/cm bevorzugt ist. Bei der Bestimmung der Laserbeständigkeit zeigen die erfindungsgemäß erhaltenen Kristalle bei einer Bestrahlung von 10 x 10$^9$ Pulsen mit einem Laser der Wellenlänge 193nm und einer Energiedichte von 10mJ/cm$^2$ nur eine geringfügige Erhöhung des Verlustkoeffizienten k um weniger als 7 mal 10$^{-4}$ cm$^{-1}$ (Extrapolation der nach der genannten Langzeitbestrahlung erhaltenen Messwerte bei unterschiedlichen Energiedichten entsprechend des in der DE 103 35 457 A1 beschriebenen Messregimes auf eine Energiedichte (Null) im Vergleich zu einer gleichen Messung vor Beginn der Langzeitbestrahlung.

Mit den so erhaltenen Scherben wurde nach dem in der WO 01/064975 beschriebenen Verfahren ein Einkristall mit einem Durchmesser von mindestens 35 cm und einer Höhe von mindestens 25 cm gezüchtet. Der Kristall zeigte einen BSDF-Wert von <15, nämlich 1,7 x 10$^{-7}$, eine RMS-Brechzahlhomogenität (nach Abzug von 36 Zernikekoeffizienten) von <13, nämlich 1,4 x 10$^{-8}$ und einen SDB-RMS-Wert in 111-Richtung von <0,15, nämlich 0,05 nm/cm.

Nach einer Bestrahlung von 10 x 10$^9$ Pulsen mit einem Laser mit einer Wellenlänge 193 nm und einer Energiedichte von 10 mJ/cm$^2$ wurde nach einer erneuten Messung des auf die Energiedichte Null extrapolierten Verlustkoeffizienten k dessen Erhöhung um 5 x 10$^{-4}$ cm$^{-1}$ gegenüber der Messung vor Beginn der Bestrahlung festgestellt.

Bevorzugte Materialien für das erfindungsgemäße Verfahren sind Erdalkalihalogenide, insbesondere Kalziumfluorid, Bariumfluorid und Magnesiumfluorid. In einer weiteren bevorzugten Ausführungsform weisen die Scherben geringfügige Dotierungen aus dreiwertigen Metallionen auf, welche als Kompensation zu einwertigen Verunreinigungen wirken. Diese Dotierungen sind insbesondere solche wie sie in der DE 10 2005 044 697 A1 beschrieben sind.

Die erfindungsgemäß erhaltenen Kristalle sind besonders zur Herstellung von optischen Komponenten in der DUV-Lithographie, sowie zur Herstellung von mit Fotolack beschichteten Wafern und somit zur Herstellung von elektronischen Geräten geeignet. Die Erfindung betrifft daher auch deren Verwendung zur Herstellung von Linsen, Prismen, Lichtleitstäben, optischen Fenstern sowie optischen Geräten für die DUV-Lithographie, insbesondere zur Herstellung von Steppern und Excimer-lasern sowohl für die Belichtungs- als auch für die Abbildungsoptiken und daher auch zur Herstellung von integrierten Schaltern, Computerchips sowie elektronische Geräte wie Computern sowie anderer Vorrichtungen, die chipartige integrierte Schaltungen enthalten.

Im erfindungsgemäßen Verfahren werden vorzugsweise Scherben gemeinsam verschmolzen, welche die gleiche Spezifikation aufweisen. Typische Spezifikationen sind in der folgenden Tabelle angegeben.

| Kriterium | 1 | 2 | 3 | 4 | 6 |
|---|---|---|---|---|---|
| Farbe | keine | keine | keine | keine | keine |
| Fluoreszenzklasse | max. 2 | max. 2 | max. 2 | max. 2 | max. 2 |
| Fluoreszenz und Farbton der Fluoreszenz | keine; rötl. u. bläul. zulässig | keine; rötl. u. bläul. zulässig | keine; rötl. u. bläul. zulässig | keine; rötl. u. bläul. zulässig | keine; rötl. u. bläul. zulässig |
| Verlustkoeffizient k (Lasermessung) bei 193 nm | 5x10$^{-4}$ [cm$^{-1}$] | 5x10$^{-4}$ [cm$^{-1}$] | | | |
| Verlustkoeffizient k (Spektrometermessung) bei 193 nm | | | 5x10$^{-4}$ [cm$^{-1}$] | 5x10$^{-4}$ [cm$^{-1}$] | 5x10$^{-4}$ [cm$^{-1}$] |
| Kleinwinkelkorn grenzenklasse | 2 | 2 | 2 | 2 | 2 |
| Streuklasse (diffus) | 0 | 1 | 1 | 1 | 1 |
| Streuklasse (diskret) (50% *) | 0 | 0 | 0 | 1 | 1 |

(fortgesetzt)

| Kriterium | 1 | 2 | 3 | 4 | 6 |
|---|---|---|---|---|---|
| Streuklasse (diskret) (100% *) | 0 | 0 | 0 | 0 | 1 |
| * Angabe - Prozentualer Anteil des Volumens des geprüften Rohkristalles | | | | | |

**Patentansprüche**

1. Verfahren zur Herstellung hochreiner, besonders strahlungsbeständiger großvolumiger Einkristalle mit geringer intrinsischer Spannungsdoppelbrechung durch Erzeugen einer Schmelze aus Kristallrohmaterial und kontrolliertem Abkühlen unter Erstarrung zu einem Kristall, **dadurch gekennzeichnet, dass** als Kristallrohmaterial Scherben und/ oder Verschnitt von bereits gezüchteten Kristallen verwendet wird, das

   1) bei einer visuellen Betrachtung bei Tageslicht keine Farbe aufweist und
   2) beim Bestrahlen mit einer Weißlichtlampe in einem Dunkelraum

      a) keine oder maximal eine gerade noch wahrnehmbare rötliche und/oder bläuliche Fluoreszenz aufweist und
      b) keine oder maximal gerade noch wahrnehmbare diffuse Streuung aufweist und
      c) keine oder nur noch schwache diskrete Streuung von maximal zwei visuell wahrnehmbaren Streuzentren pro $dm^3$ aufweist.

2. Verfahren nach Anspruch 1, **dadurch gekennzeichnet, dass** die Scherben einen aus einer Transmissionsmessung mittels Excimerlaser bei 193 nm bestimmten dekadischen Verlustkoeffizienten bei der Energiedichte Null von $\leq$ 0,0005/cm oder einen aus einer Transmissionsmessung mittels Spektrometer bei 193 nm bestimmten dekadischen Verlustkoeffizienten von $\leq$ 0,0005/cm aufweisen.

3. Verfahren nach einem der vorhergehenden Ansprüche, **dadurch gekennzeichnet, dass** benachbarte Subkörner Kleinwinkelkorngrenzen mit einer Verkippung der Kristallachsen von maximal 2° gegeneinander aufweisen.

4. Verfahren nach einem der vorhergehenden Ansprüche, **dadurch gekennzeichnet, dass** die Scherben aus $CaF_2$, $SrF_2$ oder $BaF_2$ oder Mischungen bestehen.

5. Verfahren nach einem der vorhergehenden Ansprüche, **dadurch gekennzeichnet, dass** die Kristalle mit Fremdionen dotiert sind.

6. Verfahren nach einem der vorhergehenden Ansprüche, **dadurch gekennzeichnet, dass** die Scherben vor ihrem Einschmelzen mit einem Reinigungsmittel behandelt werden.

7. Verfahren nach einem der vorhergehenden Ansprüche, **dadurch gekennzeichnet, dass** das Reinigungsmittel FCKW, ein Alkohol und/oder Wasser ist.

8. Verfahren nach einem der vorhergehenden Ansprüche, **dadurch gekennzeichnet, dass** die Lösungsmittel rückstandsfrei verdunsten.

9. Kristall für optische Anwendungen erhältlich nach einem Verfahren nach einem der Ansprüche 1 bis 8 und einer sich anschließenden Temperung, **gekennzeichnet durch** einen BSDF-Wert $<7 \times 10^{-7}$, eine RMS-Homogenität nach Abzug von 36 Zernikekoeffizienten von $<15 \times 10^{-8}$, einen SDB-RMS-Wert in 111 Richtung $<0,2$ nm/cm.

10. Verwendung eines nach einem der Ansprüche 1 bis 8 erhaltenen Kristalls oder eines Kristalls nach Anspruch 9 zur Herstellung von Linsen, Prismen, Lichtleitstäben, optischen Fenstern sowie optischen Komponenten für die DUV-Lithographie, Steppern, Excimer-Lasern, Computerchips sowie integrierten Schaltungen und elektronischen Geräten, die solche Schaltungen und Chips enthalten.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1259663 A
- DE 102004008749 A1
- DE 10335457 A1
- WO 2005080948 A
- WO 01064975 A
- DE 102005044697 A1

**In der Beschreibung aufgeführte Nicht-Patentliteratur**

- **STOVER J. C.** *Optical Scattering - measurement and analysis,* 1990